# EUROPÄISCHE PATENTANMELDUNG

(11) **EP 0 577 922 A1**
(43) Veröffentlichungstag der Anmeldung: **12.01.1994**
(21) Anmeldenummer: 93104424.2
(22) Anmeldetag: 18.03.1993
(51) Int. Cl.: C23C 14/56, C23C 14/22

(54) **Vorrichtung zur Vakuumbeschichtung von Folien**

(30) Priorität: 04.07.1992 DE 4222013
(71) Anmelder: LEYBOLD AKTIENGESELLSCHAFT, D-63450 Hanau (DE)
(72) Erfinder: Krug, Thomas, Dr., W-6458 Rodenbach (DE)

(57) **Zusammenfassung**

Beschrieben wird eine Vorrichtung zum Vakuumbeschichten von Folien mit metallischen oder nicht-metallischen Schichten, mit einer die Folie für den Beschichtungsprozeß bereitstellenden Einheit, einer gekühlten Beschichtungswalze, über die die Folie während des Beschichtungsvorganges führbar ist, mit Umlenkrollen, die für einen engen Kontakt zwischen der Folie und der Beschichtungswalze sorgen sowie mit einer durch Thermalisierung angeregten Beschichtungsquelle.

Die Erfindung zeichnet sich dadurch aus, daß zwischen der Beschichtungswalze und der Folienfläche vor dem Beschichtungsprozeß mittels einer Benetzungseinheit ein Kontaktmittel einbringbar ist.

## Beschreibung

Die Erfindung bezieht sich auf eine Vorrichtung zum Vakuumbeschichten von Folien mit metallischen oder nichtmetallischen Schichten, mit einer die Folie für den Beschichtungsprozess bereitstellenden Einheit, einer gekühlten Beschichtungswalze, über die die Folie während des Beschichtungsvorganges führbar ist, mit Umlenkrollen; die für einen engen Kontakt zwischen der Folie und der Beschichtungswalze sorgen sowie mit einer durch Thermalisierung angeregten Beschichtungsquelle.

Die Beschichtung von Folien, die in aller Regel eine nur begrenzte thermische Belastbarkeit aufweisen, erfolgt in gängigen Verfahren mit Beschichtungsquellen, die vorzugsweise durch Thermalisierung des Schichtmaterials betrieben werden. Es stellt sich daher das technische Problem, daß für eine ausreichende Schichtdickenbildung auf der Folie die Folie selbst eine gewisse Mindestzeitdauer der Beschichtungsquelle und damit verbunden der Wärmequelle ausgesetzt sein muß. Hierbei erfährt jedoch die Folie eine erhebliche Aufheizung, die bei zu langer Beschichtungsdauer oder zu hoher Beschichtungsrate thermisch zerstört werden kann.

Üblicherweise wird die zu beschichtende Folie von einer Mutterrolle, auf der die unbeschichtete Folie vorrätig ist, abgewickelt, und über diverse Umlenkrollen innerhalb einer Beschichtungskammer mit einer gekühlten Beschichtungswalze in Kontakt gebracht, die die Folie während der Beschichtung auf einer möglichst geringen Temperatur hält.

Die Kühlwirkung der Beschichtungswalze ist jedoch stark beschränkt, zumal der Wärmeübergangskoeffizient zwischen Folie und Beschichtungswalze durch den mechanischen Kontakt der Folie zur Walze bestimmt ist. Da die Rauhigkeit der Walze und der Folie nur einen unterbrochenen Flächenkontakt erlaubt, stellt sich hierdurch ein Wärmeübergangskoeffizient von ca. 30 bis 50 W/m²k ein, der jedoch für die Kühlung der Folie während des Beschichtungsvorganges aufgrund der hohen Temperaturen zu klein ist.

Nähere Untersuchungen des Wärmeflusses von der Folie zur Beschichtungswalze ergaben, daß sich während des Beschichtungsvorganges zwischen der Folie und der Beschichtungswalze ein Wasserdampfpolster bildet, das sich durch Desorption von auf der Folienoberfläche adsorbierten Wasser ergibt und die mikroskopischen Volumina ausfüllt, die durch die Rauhigkeit zwischen Folie und Beschichtungswalze gebildet werden. Hierzu wird auf den Aufsatz "Thermal Limitations in Roll Coating Processes" von W. Schwartz und W. Wagner erschienen in 'Society of Vacuum Coaters', 1985, verwiesen. Das sich dabei ausbildende Dampfpolster sorgt für eine, für die Beschichtung der Folie ausreichende Wärmeübertragung mit einem Wärmeübergangskoeffizienten zwischen 300 und 500 W/m²k .

Wärmeübergangskoeffizienten dieser Größenordnung setzen allerdings Folien voraus, die über eine anfänglich vorhandene Mindestmenge an, auf ihrer Oberfläche adsorbierten Wassers verfügen. Bei einigen Beschichtungsprozessen, beispielsweise bei der Zweiseitenbeschichtung, bei denen während der zweiten Beschichtung die Rückseite der Folie bereits beschichtet ist, ist naturgemäß durch den ersten Beschichtungsvorgang kein Wasser auf der Folienoberfläche mehr adsorbiert. Es kann daher auch kein Dampfpolster zwischen Folie und Beschichtungswalze entstehen, so daß thermische Schäden an der Folie auftreten können.

Der Erfindung liegt die Aufgabe zugrunde, eine Vorrichtung zum Vakuumbeschichten von Folien mit metallischen oder nichtmetallischen Schichten, mit einer die Folie für den Beschichtungsprozess bereitstellenden Einheit, einer gekühlten Beschichtungswalze, über die die Folie während des Beschichtungsvorganges führbar ist, mit Umlenkrollen, die für einen engen Kontakt zwischen der Folie und der Beschichtungswalze sorgen, sowie mit einer durch Thermalisierung angeregten Beschichtungsquelle, derart anzugeben, daß die Folie unabhängig von ihrer Vorgeschichte eine, den wirtschaftlichen Anforderung einer Massenproduktion angepaßten Beschichtung unbeschadet von thermischen Defekten an der Folienoberfläche übersteht. Es soll insbesondere erreicht werden, daß die Folie zur Abscheidung dickerer Schichten, der Beschichtungsquelle längere Zeit ausgesetzt werden kann, ohne dabei thermisch zerstört zu werden.

Eine erfindungsgemäße Lösung dieser Aufgabe ist im Anspruch 1 angegeben. Weiterbildungen der Erfindung sind Gegenstand der Unteransprüche.

Erfindungsgemäß wird eine Vorrichtung zum Vakuumbeschichten von Folien mit metallischen oder nichtmetallischen Schichten, mit einer die Folie für den Beschichtungsprozess bereitstellenden Einheit, einer gekühlten Beschichtungswalze, über die die Folie während des Beschichtungsvorganges führbar ist, mit Umlenkrollen, die für einen engen Kontakt zwischen der Folie und der Beschichtungswalze sorgen, sowie mit einer durch Thermalisierung angeregten Beschichtungsquelle, derart weitergebildet, daß zwischen der Beschichtungswalze und der Folienfläche vor dem Beschichtungsprozess mittels einer Benetzungseinheit ein Kontaktmittel einbringbar ist.

Die Erfindung basiert auf der Idee, die Folienfläche, die der Beschichtungswalze unmittelbar gegenüberliegt, mit einem dünnen Feuchtigkeitsfilm, vorzugsweise mit Wasser, zu überziehen, der sich innerhalb des von der Folie und der Beschichtungswalze eingeschlossenen Volumens aufgrund der Erhitzung durch die Beschichtungsquelle in ein Wasserdampfpolster umwandelt und somit für einen, für die unbeschadete Beschichtung der Folie erforderlichen hohen Wärmeübergangskoeffizienten sorgt.

Selbstverständlich ist es gleichwirkend, wenn der Feuchtigkeitsfilm auf dem Umfang der Beschichtungswalze aufgebracht wird, bevor die Folie in unmittelbaren Kontakt mit der Walze tritt.

Die Erfindung wird nachstehend ohne Beschränkung des allgemeinen Erfindungsgedankens anhand von Ausführungsbeispielen unter Bezugnahme auf die Zeichnungen exemplarisch beschrieben, auf die im übrigen bezüglich der Offenbarung aller im Text nicht näher erläuterten erfindungsgemäßen Einzelheiten ausdrücklich verwiesen wird. Es zeigen:
- Figur 1: schematische Anordnung einer Folienbeschichtungsanlage mit der erfindungsgemäßer Vorrichtung und
- Figur 2: verschiedene Ausführungsformen der erfindungsgemäßen Benetzungseinheit.

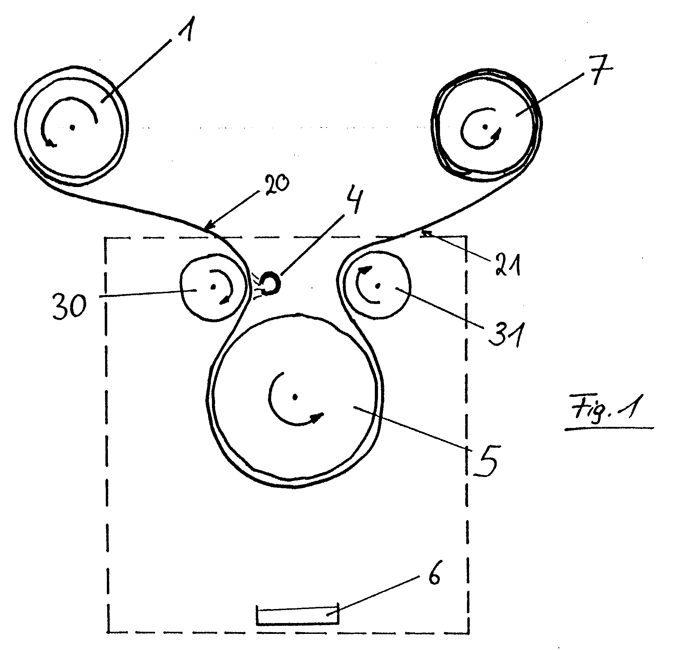

Figur 1 zeigt in schematischer Darstellung die Anordnung einer Folienbeschichtungsanlage. Von der Mutterrolle 1 wird die unbeschichtete Folie 20 abgewickelt, die über eine Umlenkrolle 30 im gespannten Zustand um die Beschichtungswalze 5 angelegt wird. Die Beschichtungswalze wird mit einem enstprechendem Kühlmittel auf ca. -20°C gekühlt, sodaß die Folie einseitig kühlbar ist. Über eine weitere Umlenkrolle 31 wird die durch die Beschichtungsquelle 6 beschichtete Folie 21 auf eine Aufnahmerolle 7 aufgewickelt. Die Beschichtung der Folie erfolgt unter Vakuumbedingungen mit einer Beschichtungsquelle 6, die entweder eine thermische Verdampferquelle, eine durch Elektronenbeschuß angeregte Beschichtungsquelle oder eine Sputterquelle ist.

Die erfindungsgemäße Benetzungseinheit 4, die ein Kontaktmittel, vorzugsweise Wasser, auf die Folienoberfläche aufbringt, ist vorteilhafterweise als rohrförmige Lanze ausgebildet, die entlang ihrer Längsseite Öffnungen aufweist, durch die das Kontaktmittel austreten kann. In der Figur 1 ist die Benetzungseinheit derart angebracht, daß die der Beschichtungswalze zugewandte Folienfläche vor Inkontakttreten mit der Beschichtungswalze mit dem Kontaktmittel benetzbar ist. Der besseren Übersicht ist in der Figur 1 die Folie jeweils etwas beabstandet von den Walzen 1, 30, 5, 31 und 7 eingezeichnet. Zusätzlich sind Drehorientierungspfeile an den Walzen angebracht, die die Folienförderrichtung der Anlage angeben. Die gestrichelt gezeichnete Linienführung soll die Begrenzungsflächen einer Vakuumkammer angebenen, innerhalb der zumindest die für die Bedampfung notwendigen Baugruppen 4, 5 und 6 enthalten sind.

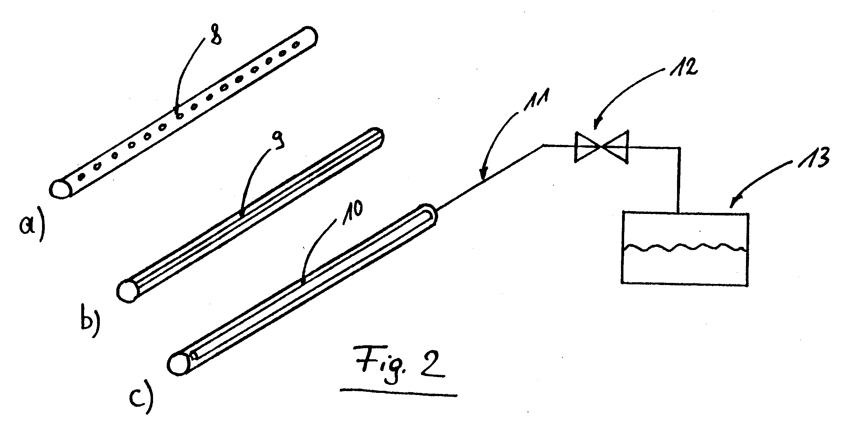

In Figur 2 sind unterschiedliche Ausgestaltungsformen für die erfindungsgemäßen Benetzungseinheiten dargestellt. Die rohrförmigen Benetzungseinheiten weisen Öffnungen auf, durch die das Kontaktmittel auf die Folienoberfläche gelangen kann. Die Öffnungen können aus gleichbeabstandeten Bohrungen 8 bestehen, wie sie beispielsweise aus Figur 2 a hevorgehen oder aus einem durchgehendem Schlitz 9 gemäß Figur 2b.

Zur gleichmäßigeren Verteilung des Kontaktmittels auf der Folie dient vorzugsweise ein schwamm- bzw. filzartiger Einsatz 10, der in den Schlitz der Benetzungseinheit einbringbar ist. Der Einsatz 10 liegt über seiner gesamten Länge an der zu benetzenden Folie auf. Da der Einsatz von der Innenseite der Benetzungseinheit gleichmäßig mit Kontaktflüssigkeit durchtränkt wird, ist für eine homogene Kontaktmittelfilmabscheidung auf der Folie gesorgt.

In Figur 2 c ist zusätzlich eine Versorgungseinheit der Benetzungseinheit mit dem Kontaktmittel dargestellt. Über eine Zuführleitung 11 wird aus einem Vorratsbehälter 13, in dem das Kontaktmittel vorgesehen ist, die Benetzungseinheit mit Kontaktmittel versorgt. Zur besseren Durchflußdosierung ist in der Zuleitungsleitung 11 ein Dosierventil 12 angebracht.

Ferner ist zur Regelung des Dampfdrucks des Kontaktmittels und damit verbunden auch der Kontaktmitteldurchsatze durch die Zuführleitung 11, die Temperatur des Kontaktmittels innerhalb des Vorratsbehälters oder innerhalb der Zuleitung einstellbar.

In bevorzugter Weise wird als Kontaktmittel Wasser verwendet. Es sind jedoch auch andere Flüssigkeiten oder Gase verwendbar, die den gewünschten Wärmeübergangskoeffizienten zwischen der Beschichtungswalze und der Folie aufweisen.

### Bezugszeichenliste

- 1: Mutterrolle
- 10: Einsatz
- 11: Zuführleitung
- 12: Dosierventil
- 13: Vorratsbehälter
- 20: unbeschichtete Folie
- 21: beschichtete Folie
- 30: Umlenkrolle
- 31: Umlenkrolle
- 4: Benetzungseinheit
- 5: Beschichtungswalze
- 6: Beschichtungsquelle
- 7: Aufnahmerolle
- 8: Bohrungen
- 9: Schlitz

## Patentansprüche

1. Vorrichtung zum Vakuumbeschichten von Folien mit metallischen oder nicht-metallischen Schichten, mit einer die Folie für den Beschichtungsprozeß bereitstellenden Einheit, einer gekühlten Beschichtungswalze (5), über die die Folie während des Beschichtungsvorganges führbar ist, mit Umlenkrollen (30, 31), die für einen engen Kontakt zwischen der Folie (20) und der Beschichtungswalze (5) sorgen sowie mit einer durch Thermalisierung angeregten Beschichtungsquelle (6),
dadurch **gekennzeichnet**, daß zwischen der Beschichtungswalze (5) und der Folienfläche vor dem Beschichtungsprozeß mittels einer Benetzungseinheit (4) ein Kontaktmittel einbringbar ist.

2. Vorrichtung nach Anspruch 1,
dadurch **gekennzeichnet**, daß die Benetzungseinheit (4) die Folienfläche mit Kontaktmittel beaufschlagt.

3. Vorrichtung nach Anspruch 1 oder 2,
dadurch **gekennzeichnet**, daß die Benetzungseinheit (4) die Beschichtungswalze (5) mit dem Kontaktmittel beaufschlagt.

4. Vorrichtung nach einem der Ansprüche 1 bis 3,
dadurch **gekennzeichnet**, daß das Kontaktmittel Wasserdampf ist.

5. Vorrichtung nach einem der Ansprüche 1 bis 4,
dadurch **gekennzeichnet**, daß unter Verwendung des Kontaktmittels ein Wärmeübergangskoeffizient zwischen Folie (20) und Beschichtungswalze (5) erzielbar ist, der größer 300 W/m²K ist.

6. Vorrichtung nach einem der Ansprüche 1 bis 5,
dadurch **gekennzeichnet**, daß die Benetzungseinheit (4) rohrförmige Gestalt besitzt, deren Länge etwa der Folienbreite entspricht und wenigstens eine Öffnung aufweist.

7. Vorrichtung nach Anspruch 6,
dadurch **gekennzeichnet**, daß die Öffnungen Bohrungen (8) in linearer Anordnung entlang der gesamten Rohrlänge entsprechen.

8. Vorrichtung nach Anspruch 6,
dadurch **gekennzeichnet**, daß die Öffnung ein Spalt (9) ist, der das Rohr in seiner gesamten Länge achsenparallel durchsetzt.

9. Vorrichtung nach Anspruch 6,
dadurch **gekennzeichnet**, daß in den Spalt ein das Kontaktmittel aufnehmendes und auf die Folie oder die Beschichtungswalze gleichmäßig übertragender Einschub (10) einbringbar ist.

10. Vorrichtung nach Anspruch 9,
dadurch **gekennzeichnet**, daß der Einschub (10) aus einem Schwamm oder einem Filz besteht.

11. Vorrichtung nach einem der Ansprüche 1 bis 10,
dadurch **gekennzeichnet**, daß die Benetzungseinheit (4) mit dem Kontaktmittel über eine Nachfülleitung (11) versorgbar ist.

12. Vorrichtung nach Anspruch 11,
dadurch **gekennzeichnet**, daß durch Druck- oder Temperatur-Regelung des Kontaktmittels in der Nachfülleitung (11) die an der Folienfläche abscheidbare Kontaktmittelmenge einstellbar ist.

13. Vorrichtung nach einem der Ansprüche 1 bis 12,
dadurch **gekennzeichnet**, daß die Benetzungseinheit (4) achsenparallel zur Beschichtungswalze (5) unmittelbar vor der Kontaktierung der Folie mit der Beschichtungswalze (5) anbringbar ist und die Folieninnenseite direkt mit dem Kontaktmittel benetzt.

14. Vorrichtung nach einem der Ansprüche 1 bis 13,
dadurch **gekennzeichnet**, daß die Beschichtungsquelle durch Elektronenbeschuß anregbar ist.

15. Vorrichtung nach einem der Ansprüche 1 bis 14,
dadurch **gekennzeichnet**, daß die Beschichtungsquelle elektrisch beheitzbar ist.

16. Vorrichtung nach einem der Ansprüche 1 bis 15,
dadurch **gekennzeichnet**, daß die Beschichtungsquelle eine Sputterquelle ist.
